# EUROPÄISCHE PATENTSCHRIFT

(11) **EP 0 867 081 B1**
(45) Veröffentlichungstag und Bekanntmachung des Hinweises auf die Patenterteilung: **04.08.1999**
(21) Anmeldenummer: 96946145.8
(22) Anmeldetag: 13.12.1996
(51) Int. Cl.: H04B 17/00

(54) **VERFAHREN UND ANORDNUNG ZUM ERFASSEN DER ÜBERTRAGUNGSEIGENSCHAFTEN VON MOBILEN, DRAHTLOSEN TELEKOMMUNIKATIONSGERÄTEN**
PROCESS AND DEVICE FOR DETECTING THE TRANSMISSION PROPERTIES OF MOBILE WIRELESS TELECOMMUNICATION DEVICES
PROCEDE ET DISPOSITIF POUR LA DETECTION DES CARACTERISTIQUES DE TRANSMISSION D'APPAREILS DE TELECOMMUNICATION SANS FIL MOBILES

(30) Priorität: 15.12.1995 DE 19546982
(43) Veröffentlichungstag der Anmeldung: 30.09.1998
(73) Patentinhaber: SIEMENS AKTIENGESELLSCHAFT, 80333 München (DE)
(72) Erfinder: GAPSKI, Dietmar, D-47058 Duisburg (DE)
(86) Internationale Anmeldenummer: DE9602402
(87) Internationale Veröffentlichungsnummer: WO9723069

(56) Entgegenhaltungen:
- DE-C- 19 517 393
- EIGHTH INTERNATIONAL CONFERENCE ON ANTENNAS AND PROPAGATION (CONF. PUBL. NO.370), EDINBURGH, UK, 30 MARCH-2 APRIL 1993, ISBN 0-85296-572-9, 1993, LONDON, UK, IEE, UK, Seiten 146-149 vol.1, XP002033337 DAMASSO E ET AL: "Indoor propagation measurements application to mobile channel modelling"
- VEHICULAR TECHNOLOGY SOCIETY 42ND VTS CONFERENCE. FRONTIERS OF TECHNOLOGY. FROM PIONEERS TO THE 21ST CENTURY (CAT. NO.92CH3159-1), DENVER, CO, USA, 10-13 MAY 1992, ISBN 0-7803-0673-2, 1992, NEW YORK, NY, USA, IEEE, USA, Seiten 621-624 vol.2, XP002033338 MORIYAMA E ET AL: "2.6 GHz multipath characteristics measurement in a shielded building"

## Beschreibung

Die Erfindung betrifft ein Verfahren zum Erfassen der Übertragungseigenschaften von mobilen, drahtlosen Telekommunikationsgeräten gemäß dem Oberbegriff des Patentanspruches 1 und eine Anordnung zum Erfassen der Übertragungseigenschaften von mobilen, drahtlosen Telekommunikationsgeräten gemäß dem Oberbegriff des Patentanspruches 4.

Mobile drahtlose Telekommunikationsgeräte sind beispielsweise Schnurlostelefone, bestehend aus einer Schnurlos-Basisstation und mit der Basisstation über eine Funkstrecke durch Telekommunikation verbundene Schnurlos-Mobilteile, nach dem DECT/ GAP-Standard (**D**igital **E**uropean **C**ordless **T**elecommunication; vgl. **(1):** Nachrichtentechnik Elektronik 42 (1992, Jan./Feb.), Nr. 1, Berlin, DE; U.Pilger: "Struktur des DECT-Standards", Seiten 23 bis 29; **(2):** Philips Telecommunication Review, Vol. 49, Nr. 3, Sept. 1991; R.Mulder: "DECT, A Universal Cordless Access System", Seiten 68 bis 73;/**G**eneric **A**ccess **P**rofile; vgl. ETSI-Publikation prETS 300444, April 1995, Final Draft, ETSI, FR) oder als Mobilfunktelefone nach dem GSM-Standard (**G**roupe **S**péciale **M**obile oder **G**lobal **S**ystem for **M**obile **C**ommunication; vgl. Informatik Spektrum 14 (1991) Juni, Nr. 3, Berlin, DE; A.Mann: "Der GSM-Standard - Grundlage für digitale europäische Mobilfunknetze", Seiten 137 bis 152).

Neben den genannten Telekommunikationsgeräten gibt es weitere Geräte der gleichen Gattung (mobil, drahtlos), die auf andere Telekommunikationsstandards und/oder andere Multiplexzugriffsverfahren basieren.

Das mobile drahtlose Telekommunikationsgerät ist ein Nachrichtensystem mit einer drahtlosen Übertragungsstrecke zwischen einer Nachrichtenquelle (z.B. Schnurlos-Basisstation) und einer Nachrichtensenke (z.B. Schnurlos-Mobilteil) zur Nachrichtenverarbeitung und -übertragung, bei dem an jedem x-beliebigen Ort des Nachrichtensystems (mobiler Charakter des Nachrichtensystems) die Nachrichten in beiden Übertragungsrichtungen (Duplex-Betrieb) übertragen werden. Die Nachrichtenverarbeitung kann dabei digital oder analog sein. Darüber hinaus erfolgt die Nachrichtenverarbeitung und die drahtlose Nachrichtenübertragung vorzugsweise nach diversen Funkstandards, wie DECT, WCPS (amerikanische DECT-Version), PAS (jap. DECT-Version), GSM einschließlich des Derivats DCS1800, ADC (amerikanische GSM-Version), JDC (japanische GSM-Version) etc. Als drahtlose Übertragungstechnik können neben der Funkübertragung auch andere drahtlose Übertragungsarten eingesetzt werden, wie z. B. die Infrarot-Übertragung.

"Nachricht" ist ein übergeordneter Begriff, der sowohl für den Sinngehalt (Information) als auch für die physikalische Repräsentation (Signal) steht. Signale können dabei z. B.
(1) Bilder,
(2) gesprochene Wörter,
(3) geschriebene Wörter,
(4) verschlüsselte Wörter oder Bilder
reprasentieren.

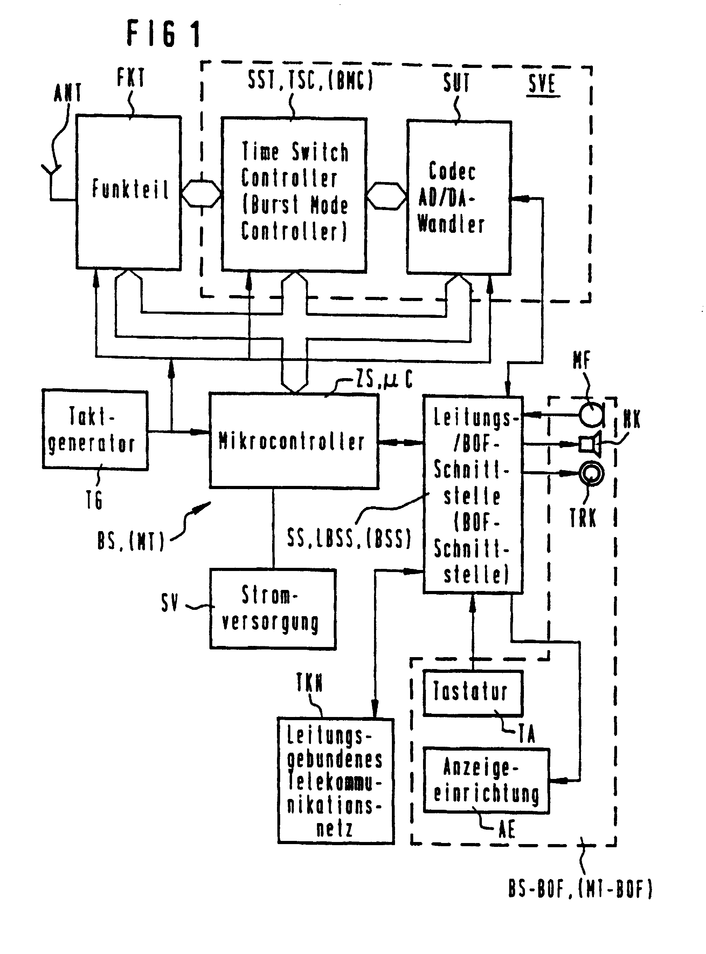

Figur 1 zeigt ausgehend von der Druckschrift Components 31 (1993), Heft 6, Seiten 215 bis 218; S. Althammer, D. Brückmann: "Hochoptimierte IC's für DECT-Schnurlostelefone" den prinzipiellen Schaltungsaufbau einer Schnurlos-Basisstation BS und eines Schnurlos-Mobilteils MT. Dieser besteht aus einem Funkteil FKT mit mindestens einer Antenne ANT, einer Signalverarbeitungseinheit SVE mit einem Signalsteuerungsteil SST und einem Singalumformungsteil SUT, einem Taktgenerator TG, einer als Mikrocontroller µC ausgebildeten Zentralen Steuerung ZS, einer Schnittstelle SS und einer Stromversorgung SV, die in der dargestellten Weise miteinander verbunden sind. Die prinzipielle Funktionsweise des Schaltungsaufbaus ist beispielsweise in der vorstehend zitierten Druckschrift Components 31 (1993), Heft 6, Seiten 215 bis 218 beschrieben. Von den genannten Schaltungseinheiten sind das Signalsteuerungsteil SST und die Schnittstelle SS für die Basisstation BS und das Mobilteil MT unterschiedlich ausgebildet. Zur Kennzeichnung dieser Unterschiede sind die das Mobilteil MT betreffende Schaltungseinheiten eingeklammert "()".

Das Signalsteuerungsteil SST ist in der Basisstation BS als Time Switch Controller TSC und in dem Mobilteil MT als Burst Mode Controller BMC ausgebildet. Der wesentliche Unterschied zwischen den beiden Signalsteuerungsteilen TSC, BMC besteht darin, daß der basisstationsspezifische Signalsteuerungsteil TSC gegenüber dem mobilteilspezifischen Signalsteuerungsteil BMC zusätzlich Vermittlungsfunktionen (Switch-Funktionen) übernimmt.

Die Schnittstelle SS ist in der Basisstation BS als Leitungs/BOF-Schnittstelle LBSS und in dem Mobilteil MT als BOF-Schnittstelle ausgebildet. Über die Leitungs-/BOF-Schnittstelle LBSS ist die Basisstation BS an das leitungsgebundene Telekommunikationsnetz TKN angeschlossen und eine gegebenenfalls vorhandene basisstationsspezifische Bedienoberfläche BS-BOF mit den übrigen Schaltungseinheiten der Basisstation BS verbunden. Über die BOF-Schnittstelle BSS ist eine mobilteilspezifische Bedienoberfläche MT-BOF mit den übrigen Schaltungseinheiten des Mobilteils MT verbunden. Die basisstationsspezifische Bedienoberfläche BS-BOF und die mobilteilspezifische Bedienoberfläche MT-BOF weisen jeweils eine Tastatur TA, eine Anzeigeeinrichtung (Display) AE, ein Mikrofon MF, eine Hörkapsel HK und eine Tonrufklingel TRK auf.

Ein prinzipielles Problem bei der Entwicklung von Telekommunikationsgeräten der vorstehend umrissenen Art ist die meßtechnische Erfassung von Übertragungseigenschaften des Telekommunikationsgerätes. Hierzu zählen die Erfassung von Ausbreitungspfaden, die Optimierung der drahtlosen übertragungsstrecke (Funkstrecke), die Bestimmung von Empfängerempfindlichkeit und Sendeleistung. Während sich die Empfängerempfindlichkeit und Sendeleistung im allgemeinen einfach bestimmen lassen, gibt es bei der Erfassung der Ausbreitungspfade und der Optimierung der Funkstrecke häufig Probleme.

Die Erfassung der Ausbreitungspfade und die Optimierung der Funkstrecke erfolgt gemäß der Druckschrift "Eighth International Conference on Antennas and Propagation, Edinburgh, UK, 30. März - 2. April 1993, ISBN 0-85296-572-9, 1993, London, UK, Seiten 146 - 149, vol. 1, "Indoor propagation measurements: Appliction to Mobile Channel Modelling" von E. Damosso et al. durch statische Messungen.

Alternativ ist es auch möglich, die Ausbreitungspfade und die Optimierung der Funkstrecke mittels Ausbreitungsmessungen oder computergestützter Simulationen zu erfassen. Diese Vorgehensweisen sind jedoch zeitaufwendig und ungenau bzw. zeitaufwendig und kompliziert.

Aus der nachveröffentlichten DE 195 17 393 C1 ist ein Verfahren und eine Anordnung zum Prüfen von Funkkanälen des Telekommunikationssystem mit einem Mobilteil und einer Basisstation bekannt, bei der zur Vorabbeurteilung des jeweiligen Funkkanals bezüglich seiner Übertragungsqualität die von einer Steuerungseinrichtung erzeugten Testdaten in einem für die Netzinformationen vorgesehenen Informationsfeld vom Mobilteil zur Basisstation übertragen und die von der Basisstation nach der Übertragung empfangenen Testdaten mit Testdaten verglichen werden, die von einer mit der Basisstation verbundenen Steuerungseinrichtung erzeugt werden. Von der mit der Basisstation verbundenen Steuerungseinrichtung wird aus dem Vergleichsergebnis eine Datenfehlerrate ermittelt und zusammen mit Kanalparametern des Funkkanals, die parallel zu den Testdaten empfangen werden, zur Überprüfung des jeweiligen Funkkanals in bezug auf seine Übertragungsqualität ausgewertet.

Die der Erfindung zugrundeliegende Aufgabe besteht darin, die Übertragungseigenschaften von mobilen drahtlosen Telekommunikationsgeräten der eingangs angegebenen Art einfach, schnell und genau zu erfassen.

Diese Aufgabe wird ausgehend von
a) dem in dem Oberbegriff des Patentanspruches 1 definierten Verfahren durch die in dem Kennzeichen des Patentanspruches 1 angegebenen Merkmale gelöst,
b) der in dem Oberbegriff des Patentanspruches 4 definierten Anordnung durch die in dem Kennzeichen des Patentanspruches 4 angegebenen Merkmale gelöst.

Die der Erfindung zugrundeliegende Idee besteht darin, für mobile drahtlose Telekommunikationsgeräte, z.B. Schnurlostelefone, eine künstliche (Test-)Umgebung in Form einer geschirmten Kammer mit teilreflektierenden Innenwänden, einer gleichmäßigen elektromagnetischen Feldverteilung in der Kammer, einer Bewegungsvorrichtung zum zufälligen Bewegen einer ersten Sende-/Empfangseinrichtung - z.B. ein Schnurlos-Mobilteil oder eine Schnurlos-Basisstation - für eine vorgegebene Zeitdauer zu schaffen.

Vorteilhafte Weiterbildungen der Erfindung sind in den Unteransprüchen angegeben.

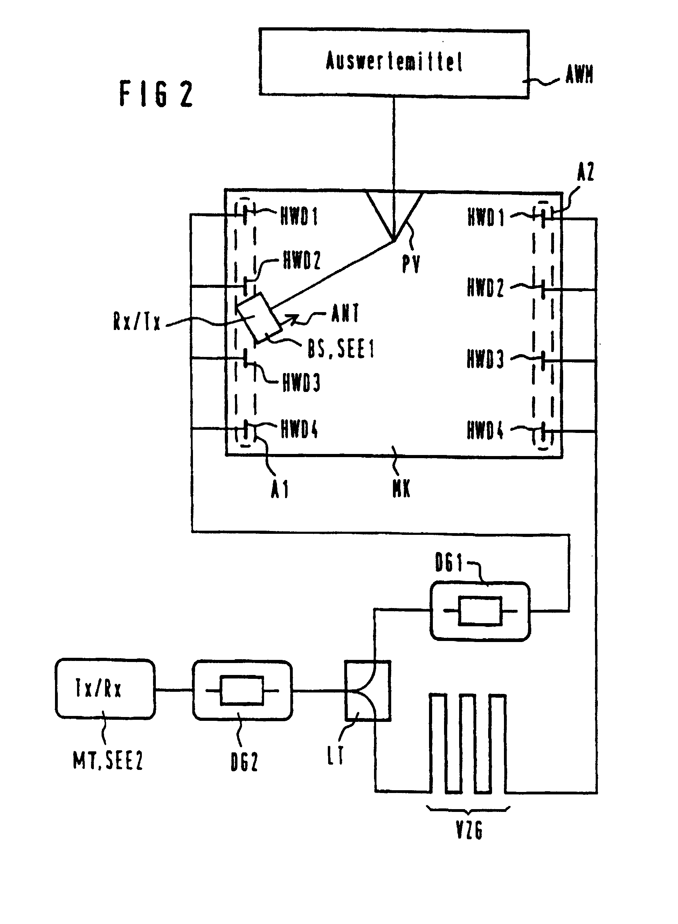

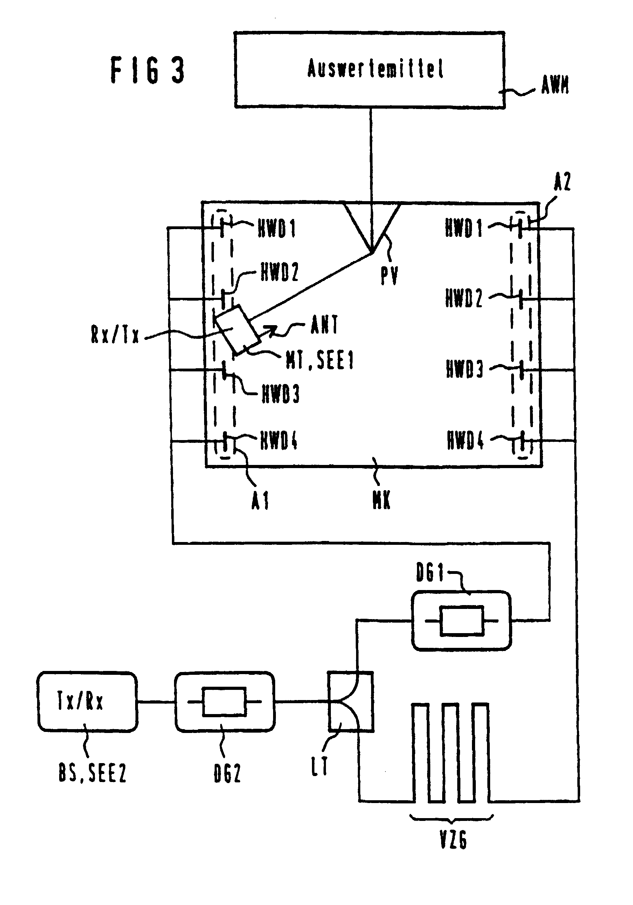

Zwei Ausführungsbeispiele der Erfindung werden anhand der Figuren 2 und 3 erläutert.

FIG 2 zeigt ein erstes Ausführungsbeispiel, bei dem z.B. die Übertragungseigenschaften der Basisstation BS nach FIG 1 erfaßt werden. Die als erste Sende-/Empfangseinrichtung SEE1 ausgebildete Basisstation BS hängt dazu in einer Meßkammer MK (FIG 2 zeigt die zweidimensionale Darstellung dieser Kammer) an einer Pendelvorrichtung PV. Die Meßkammer MK ist aus metallischem Material, z.B. Blech, hergestellt, um eine totale Abschirmung der Basisstation BS gegen äußere Feldeinflüsse (Störungen) zu erreichen. Eine solche Kammer kann auch durch einen mit metallischem Material, z.B. Kupferblech, ausgekleideten Gebäuderaum realisiert werden.

Bevor im einzelnen auf die weitere Ausgestaltung der Meßkammer MK eingegangen wird, sind die Erfordernisse der Meßkammer MK im Zusammenhang mit der Erfassung der übertragungseigenschaften zu klären. Dazu werden die Übertragungsverhältnisse der Basisstation BS in einer realen nicht abgeschirmten Umgebung betrachtet.

### Ausbreitungsbedingungen (Delay Spread)

Unter realen Ausbreitungsbedingungen findet sich auf dem Funkweg ein direkter Pfad, nämlich die kürzeste Verbindung zwischen Sender und Empfänger, und ein oder mehrere indirekte Pfade, welche sich gegenüber dem direkten Pfad durch eine größere Signallaufzeit auszeichnen).

Um einerseits den Aufwand bei der Nachbildung des "Delay Spread"-Phänomens gering zu halten und andererseits eine realitätsnahe Simulation zu erreichen, wird neben einem direkten Pfad (unverzögerten Pfad) nur ein einziger indirekter Pfad (verzögerter Pfad) erzeugt. Die Leistung des verzögerten Pfades sowie die Verzögerungszeit sind jedoch frei wählbar. Die Meßkammer läßt sich jedoch generell auf beliebig viele Pfade aufrüsten. Dies bedeutet jedoch, daß der Meßaufwand vervielfacht wird, weil bei jedem neu hinzukommenden Pfad ein Freiheitsgrad mehr vorhanden ist. An dieser Stelle sei bereits darauf hingewiesen, daß bei der praktischen Realisierung der Kammer mit einem direkten und indirekten Ausbreitungspfad durch mehrere kleine Zeitdifferenzen (ns-Bereich) verzögerte Pfade auftreten.

### Statistische Berücksichtigung der realitatsnahen Raumwinkel

Im statistischen Mittel kann man davon ausgehen, daß die bevorzugte Benutzungsrichtung bei einem schnurlosen Telefon in der horizontalen Ebene liegt. Um zu einer realitätsnahen Messung zu gelangen, ist es somit sinnvoll, die Meßwerte in der Horizontalen gegenüber der Vertikalen um ca. 25 % statistisch stärker zu berücksichtigen.

### Mittlere Verzögerung eines Funksignal

Bis jetzt ist nicht bekannt, welche mittlere Verzögerung ein Funksignal, z.B. ein DECT-Signal, in einer typischen Umgebung des Schnurlostelefons erfährt. Dieses Wissen könnte die Anzahl der Messungen in der Kammer reduzieren, indem statistisch irrelevante Fälle nicht weiter untersucht werden.

### Feldstärkeverlauf

Um in der Meßkanmer MK die Übertragungseigenschaften messen und auswerten zu können, muß ein realitätsnaher Feldstärkeverlauf über den Ort realisiert werden. Dieser bekannte Verlauf mit den vielen Feldstärkeeinbrüchen wird durch Reflexionen an den zum Teil reflektierenden Wänden erreicht. Um genügend statistische Sicherheit bei der Messung zu erreichen, sollten die Innenabmessungen der Kammer den Funksignalen angepaßt werden.

Hieraus ergibt sich folgender weiterer Aufbau der Meßkanmer MK:

Im Inneren (an den Innenwänden) ist die Kammer mit Absorbermaterial ausgekleidet, um die Hochfrequenzenergie nicht zu lange in der Kammer zirkulieren zu lassen. Dabei werden kurze (wenige cm) Absorber verwendet.

Ein Teil dieser Absorber wird mit einer reflektierenden Schicht (z. B. Alufolie) abgedeckt. Hierdurch wird der Anteil von reflektierten zu transmittierten Wellen eingestellt.

Um eine gleichmäßige Feldverteilung der Meßkammer MK zu erreichen, sind mindestens zwei, z.B. linear polarisierte, Antennen A1, A2 angebracht werden, welche den Raum gleichmäßig "ausleuchten". Die Antenne A1, A2 ist dabei z.B. als Antennenanordnung von vier übereinander angeordneten Halbwellendipolen HWD1...HWD4 ausgebildet. Die vier Dipole werden übereinander und gleichmäßig zwischen Boden und Decke der Meßkammer MK verteilt. Der Abstand der beiden Antennenanordnungen darf nicht zu groß sein, um bei Bewegung des Meßobjekte die Bevorzugung einer Antenne zu vermeiden. Eine zu starke Annäherung der Antennen aneinander führt unter Umständen zu größvolumigen Interferenzmustern, die im Interesse einer hohen statistischen Meßsicherheit zu vermeiden sind.

Die Antenne A1 ist über ein erstes Dämpfungsglied DG1 mit einem Leistungsteiler LT verbunden, während die Antenne A2 über ein Verzögerungsglied VZG mit dem Leistungsteiler LT verbunden ist. Auf diese Weise sind die beiden vorstehend erwähnten Pfade, der direkte Pfad über die Antenne A1 und der indirekte Pfad über die Antenne A2, realisiert worden. Der Leistungsteiler LT ist eingangsseitig über ein zweites Dämpfungsglied DG2 mit einer zweiten Sende-/Empfangseinrichtung SEE2 verbunden. Diese Sende-/Empfangseinrichtung SEE2 ist z.B. das Mobilteil MT nach FIG 1.

Das zweite Dämpfungsglied DG2 dient zum Einstellen der gesamten Strahlungsleistung, während das erste Dämpfungsglied DG1 nur dazu verwendet wird, die Dämpfung des Verzögerungspfades auszugleichen. Dadurch erhalten beide Antennen die gleiche Leistung. Zudem sind die Verzögerungszeit und die Ausgangsleistung variabel und unabhängig voneinander einstellbar.

Das Verzögerungsglied VZG in dem indirekten Pfad wird z.B. durch ein gegenüber dem Koaxialkabel in dem direkten Pfad verlängertes Koaxialkabel realisiert. Ein Meter Koaxialkabel mit festem Polyäthylendielektrikum erwirkt eine Verzögerung von 5 nsec. Verwendet man mehrere Koaxialkabel mit binärer Wichtung der Längen, läßt sich die Verzögerungszeit fein einstellen.

Bei dem beschriebenen Ausführungsbeispiel ist das Mobilteil MT als Sendegerät Tx und die Basisstation BS in der Meßkammer als Empfangsgerät Rx ausgebildet. Alternativ ist es auch möglich, daß als Sendegerät Tx ein Signalgenerator verwendet wird.

Außerdem ist es auch möglich, daß die Basistation BS als Sendegerät Tx und das Mobilteil MT als Empfangsgerät Rx ausgebildet ist.

Während die erste Sende-/Empfangseinrichtung SEE1 mit der Antenne ANT durch die Pendelvorrichtung PV ständig in Bewegung ist (mobil), ist die zweite Sende-/Empfangseinrichtung SEE2 mit den Antennen A1, A2 stationär ausgebildet. Die Bewegung der Sende-/Empfangseinrichtung SEE1 (Meßobjekt) ist ein gewichtet-chaotischer Bewegungsablauf für eine aus Auswertegründen vorgebene Zeitdauer.

Chaotisch bedeutet dabei, daß die Bewegung keine Regelmäßigkeit besitzt. Dadurch werden jegliche systematische Fehler bei der Messung und Auswertung der Übertragungseigenschaften des Meßobjektes vermieden.

Gewichtet bedeutet, daß die Bewegung auf den meßobjektspezifischen Raumwinkel ausgelegt ist.

Die Bevorzugung der horizontalen Ebene ermöglicht eine Vereinfachung der Bewegungsmechanik. Um alle Raumwinkel statistisch gleich zu erfassen, ist eine komplexe Mechanik notwendig. Läßt man eine Gewichtung zu, so führt bereits eine einfache Pendelvorrichtung PV (z.B. ein Pendel) zum gewünschten Ziel.

Wird das Pendel mit einer großen Amplitude zum Pendeln angeregt und wird gewartet, bis die Amplitude wieder einen kleinen Wert angenommen hat, bevor das Pendel erneut angestoßen wird, ergibt sich durch den exponentiellen Abfall der Schwingamplitude über der Zeit in etwa die gewünschte statistische Wichtung der Raumwinkel über der Zeit.

Zur Auswertung der mit der beschriebenen Meßanordnung erfaßbaren Übertragungseigenschaften der Basisstation BS als Sendegerät Tx oder als Empfangsgerät Rx ist die Basisstation BS mit Auswertemittel AWM, z.B einen Personal Computer, verbunden. Mit den Auswertemitteln AWM werden z.B. beim Nachrichtenaustausch zwischen der Basistation BS und dem Mobilteil MT übertragene nachrichtenimmanente Informationen (Kriterien für die Übertragungsqualität), z.B. die Bitfehlerrate, die Tonqualität bei der Sprachübertragung, ausgewertet. Diese Auswertung erfolgt z.B. durch einen programmgestützten Vergleich von gesendeter Nachricht und empfangener Nachricht.

Als Übertragungseigenschaften können mit dem Aufbau beispielsweise die Korrelation von Antennenanordnungen und die Effektivität von Antenna Diversity-Anordnungen erfaßt werden.

Unterschiedliche Antennenanordnungen sind somit in ihrer Leistungsfähigkeit direkt bestimmbar und objektiv vergleichbar.

Mit der vorgestellten Meßkammer läßt sich realitätsnah jede beliebige Ausbreitungsbedingung einstellen. Grundsätzlich ist diese Kammer eine Lösung für fast alle Meßprobleme, die in der Realität zwischen den beiden 50 Ohm Testpunkten von Basisstation und Mobilteil auftreten. Beispielsweise wäre selbst die Analyse von Fremdprodukten über die Messung der Verzerrungen bzw. Störungen denkbar.

FIG 3 zeigt ein zweites Ausführungsbeispiel, bei dem die Rollen von Basistation BS und Mobilteil MT gemäß dem ersten Ausführungsbeispiel vertauscht sind. Das Mobilteil MT ist jetzt Meßobjekt und befindet sich in der Meßkammer MK. Ansonsten treffen die Ausführungen zum ersten Ausführungsbeispiel auch auf das zweite Ausführungsbeispiel zu.

## Patentansprüche

1. Verfahren zum Erfassen der Übertragungseigenschaften von mobilen drahtlosen Telekommunikationsgeräten, wobei das Telekommunikationsgerät eine erste Sende-/Empfangseinrichtung (SEE1, BS, MT) und eine zweite Sende-/Empfangseinrichtung (SEE2, BS, MT) aufweist, die über eine drahtlose Übertragungstrecke Nachrichten austauschen,
dadurch gekennzeichnet, daß
a) die erste Sende-/Empfangseinrichtung (SEE1, BS, MT) in bezug auf die ruhende zweite Sende-/Empfangseinrichtung (SEE2, BS, MT) in einem bezüglich eines realitätsnahen Feldstärkeverlaufs gleichmäßig verteilten ungestörten elektromagnetischen Feld zufällig - nach chaotischen Gesichtspunkten - bewegt wird,
b) die Nachrichten in bezug auf mindestens ein die Übertragungsqualität angebendes nachrichtenimnnanentes Kriterium ausgewertet werden,
c) die erste Sende-/Empfangseinrichtung (SEE1, BS, MT) für eine vorgegebene Zeitdauer bewegt wird, damit das die Übertragungsqualität angebende Kriterium nach statistischen Gesichtspunkten sicher ermittelt ist.

2. Verfahren nach Anspruch 1, dadurch gekennzeichnet, daß als nachrichtenimmanentes Kriterium die Bitfehlerrate verwendet wird.

3. Verfahren nach Anspruch 1, dadurch gekennzeichnet, daß als nachrichtenimmanentes Kriterium die Tonqualität bei einer Sprachübertragung verwendet wird.

4. Anordnung zum Erfassen der Übertragungseigenschaften von mobilen drahtlosen Telekommunikationsgeräten, wobei das Telekommunikationsgerät eine erste Sende-/Empfangseinrichtung (SEE1, BS, MT) und eine zweite Sende-/Empfangseinrichtung (SEE2, BS, MT) aufweist, die über eine drahtlose Übertragungstrecke Nachrichten austauschen, dadurch gekennzeichnet, daß
a) eine geschirmte, geschlossene Kammer (MK) mit teilreflektierenden Innenwänden vorgesehen ist,
b) mindestens zwei der zweiten Sende-/Empfangseinrichtung (SEE2, BS, MT) zugeordnete Antennen (A1, A2, HDW1...HDW4) derart in der Kammer (MK) angeordnet sind, daß eine bezüglich eines realitätsnahen Feldstärkeverlaufs gleichmäßige ungestörte elektromagnetische Feldverteilung in der Kammer (MK) entsteht,
c) eine in der Kammer (MK) angeordnete Bewegungsvorrichtung (PV) vorgesehen ist, die derart ausgebildet und mit der ersten Sende-/Empfangseinrichtung (SEE1, BS,MT) verbunden ist, daß die erste Sende-/Empfangseinrichtung (SEE1, BS, MT) zufällig - nach chaotischen Gesichtspunkten - bewegbar ist,
d) Auswertemittel (AWM) vorgesehen sind, die die Nachrichten in bezug auf mindestens ein die Übertragungsqualität angebendes nachrichtenimmanentes Kriterium auswerten,
e) die Bewegungsvorrichtung (PV) derart ausgebildet ist, daß die erste Sende-/Empfangseinrichtung (SEE1, BS, MT) für eine vorgegebene Zeitdauer bewegt wird, damit das die Übertragungsqualität angebende Kriterium nach statistischen Gesichtspunkten sicher ermittelt ist.

5. Anordnung nach Anspruch 4, dadurch gekennzeichnet,daß das nachrichtenimmanente Kriterium die Bitfehlerrate ist.

6. Anordnung nach Anspruch 4, dadurch gekennzeichnet,daß das nachrichteninamnente Kriterium die Tonqualität einer Sprachübertragung ist.

7. Anordnung nach einem der Ansprüche 4 bis 6, dadurch gekennzeichnet, daß die Bewegungsvorrichtung (PV) als Pendelvorrichtung ausgebildet ist.

8. Anordnung nach einem der Ansprüche 4 bis 7, dadurch gekennzeichnet, daß die Antenne (A1, A2) als Antennenanordnung von mehreren Halbwellendipolen (HWD1..HWD4) ausgebildet ist.

9. Anordnung nach einem der Ansprüche 4 bis 8, dadurch gekennzeichnet, daß die erste Sende-/Empfangseinrichtung (SEE1, BS, MT) als Schnurlos-Mobilteil (MT) und die zweite Sende/Empfangseinrichtung (SEE2, BS, MT) als Schnurlos-Basisstation (BS) ausgebildet ist.

10. Anordnung nach einem der Ansprüche 4 bis 8, dadurch gekennzeichnet, daß die erste Sende-/Empfangseinrichtung (SEE1, BS, MT) als Schnurlos- Basisstation (BS) und die zweite Sende-/Empfangseinrichtung (SEE2, BS, MT) als Schnurlos-Mobilteil (MT) ausgebildet ist.

## Claims

1. Process for detecting the transmission properties of mobile wireless telecommunications devices, the telecommunications device having a first transmitter/receiver (SEE1, BS, MT) and a second transmitter/receiver (SEE2, BS, MT) which exchange messages via a wireless transmission link, characterized in that
a) the first transmitter/receiver (SEE1, BS, MT) is moved randomly, in chaotic terms, with respect to the stationary second transmitter/receiver (SEE2, BS, MT) in an undisrupted electromagnetic field which is distributed uniformly in respect to a field strength profile which is close to real conditions,
b) the messages are evaluated with respect to at least one criterion which indicates the transmission quality and is inherent in the messages,
c) the first transmitter/receiver (SEE1, BS, MT) is moved for a prescribed time period, so that the criterion indicating the transmission quality is reliably determined in statistical terms.

2. Process according to Claim 1, characterized in that the bit error rate is used as criterion which is inherent in the messages.

3. Process according to Claim 1, characterized in that the sound quality during a voice transmission is used as criterion which is inherent in the messages.

4. Arrangement for detecting the transmission properties of mobile wireless telecommunications devices, the telecommunications device having a first transmitter/receiver (SEE1, BS, MT) and a second transmitter/receiver (SEE2, BS, MT) which exchange messages via a wireless transmission link, characterized in that
a) a shielded, enclosed chamber (MK) with partially reflective inner walls is provided,
b) at least two antennas (A1, A2, HDW1...HDW4). assigned to the second transmitter/receiver (SEE2, BS, MT) are arranged in the chamber (MK) in such a way that an undisrupted electromagnetic field distribution which is uniform in respect of a field strength profile which is close to real conditions is brought about in the chamber (MK),
c) a movement device (PV) which is arranged in the chamber (MK) is provided and is designed in such a way and connected to the first transmitter/receiver (SEE1, BS, MT) in such a way that the first transmitter/receiver (SEE1, BS, MT) can be moved randomly, in chaotic terms,
d) evaluation means (AWM) are provided, which evaluate the messages in respect of at least one criterion which indicates the transmission quality and is inherent in the messages,
e) the movement device (PV) is designed in such a way that the first transmitter/receiver (SEE1, BS, MT) is moved for a predetermined time period so that the criterion which indicates the transmission quality is determined reliably in statistical terms.

5. Arrangement according to Claim 4, characterized in that the criterion which is inherent in the messages is the bit error rate.

6. Arrangement according to Claim 4, characterized in that the criterion which is inherent in the messages is the sound quality of a voice transmission.

7. Arrangement according to one of Claims 4 to 6, characterized in that the movement device (PV) is designed as a pendulum device.

8. Arrangement according to one of Claims 4 to 7, characterized in that the antenna (A1, A2) is designed as an antenna arrangement of a plurality of half-wave dipoles (HWD1..HWD4).

9. Arrangement according to one of Claims 4 to 8, characterized in that the first transmitter/receiver (SEE1, BS, MT) is designed as a cordless mobile unit (MT) and the second transmitter/receiver (SEE2, BS, MT) is designed as a cordless base station (BS).

10. Arrangement according to one of Claims 4 to 8, characterized in that the first transmitter/receiver (SEE1, BS, MT) is designed as a cordless base station (BS) and the second transmitter/receiver (SEE2, BS, MT) is designed as a cordless mobile unit (MT).

## Revendications

1. Procédé pour relever les caractéristiques de transmission d'appareils de télécommunication mobiles, sans fil, l'appareil de télécommunication comportant un premier dispositif (SEE1, BS, MT) d'émission/réception et un deuxième dispositif (SEE2, BS, MT) d'émission/réception qui échangent des données par l'intermédiaire d'une liaison radioélectrique sans fil, caractérisé en ce que
a) le premier dispositif (SEE1, BS, MT) d'émission/réception est mis en mouvement relatif par rapport au deuxième dispositif (SEE2, BS, MT) d'émission/réception au repos de manière aléatoire - suivant des points de vue chaotiques - dans un champ électromagnétique non parasité, réparti de manière uniforme par rapport à une courbe d'intensité de champ proche de la réalité,
b) les données sont exploitées relativement à au moins un critère immanent aux données et indiquant la qualité des transmissions,
c) le premier dispositif (SEE1, BS, MT) d'émission/transmission est déplacé pendant une durée prescrite afin que le critère indiquant la qualité de transmission soit déterminé de manière sûre suivant des points de vue statistiques.

2. Procédé suivant la revendication 1, caractérisé en ce que l'on utilise comme critère immanent aux données le taux d'erreurs sur les bits.

3. Procédé suivant la revendication 1, caractérisé en ce que l'on utilise comme critère immanent aux données la qualité du son lors d'une transmission de la parole.

4. Dispositif pour relever les caractéristiques de transmission d'appareils de télécommunication mobiles, sans fil, l'appareil de télécommunication comportant un premier dispositif (SEE1, BS, MT) d'émission/réception et un deuxième dispositif (SEE2, BS, MT) d'émission/réception qui échangent des données par l'intermédiaire d'une liaison radioélectrique sans fil, caractérisé en ce que
a) il est prévu une chambre (MK) fermée, blindée, comportant des parois intérieures partiellement réfléchissantes,
b) au moins deux antennes (A1, A2, HDW1 ... HDW4) associées au deuxième dispositif (SEE2, BS, MT) d'émission/réception sont montées dans la chambre (MK) de manière à obtenir dans la chambre (MK) une répartition de champ électromagnétique non parasité, uniforme relativement à une courbe d'intensité de champ proche de la réalité,
c) il est prévu du dispositif (PV) de déplacement, monté dans la chambre (MK), qui est réalisé et qui est relié au premier dispositif (SEE1, BS, MT) d'émission/ réception de manière que le premier dispositif (SEE1, BS, MT) d'émission/réception puisse être déplacé de manière aléatoire - suivant des points de vue chaotiques -
d) il est prévu des moyens (AWM) d'exploitation qui exploitent les données relativement à au moins un critère immanent aux données et indiquant la qualité de transmission,
e) le dispositif (PV) de déplacement est réalisé de manière à déplacer le premier dispositif (SEE1, BS, MT) d'émission/réception pendant une durée prescrite afin que le critère indiquant la qualité de transmission soit déterminé de manière sure suivant des points de vue statistiques.

5. Dispositif suivant la revendication 4, caractérisé en ce que le critère immanent aux données est le taux d'erreurs sur les bits.

6. Dispositif suivant la revendication 4, caractérisé en ce que le critère immanent aux données est la qualité du son d'une transmission de la parole.

7. Dispositif suivant l'une des revendications 4 à 6, caractérisé en ce que le dispositif (PV) de déplacement est réalisé en dispositif de balancier.

8. Dispositif suivant l'une des revendications 4 à 7, caractérisé en ce que l'antenne (A1, A2) est réalisée en dispositif d'antenne constitué de plusieurs bipoles (HWD1...HWD4) à demi-onde.

9. Dispositif suivant l'une des revendications 4 à 8, caractérisé en ce que le premier dispositif (SEE1, BS, MT) d'émission/réception est réalisé en partie (MT) mobile sans fil et en ce que le deuxième dispositif (SEE2, BS, MT) d'émission/réception est réalisé en station (BS) de base sans fil.

10. Dispositif suivant l'une des revendications 4 à 8, caractérisé en ce que le premier dispositif (SEE1, BS, MT) d'émission/réception est réalisé en station (BS) de base sans fil et en ce que le deuxième dispositif (SEE2, BS, MT) d'émission/réception est réalisé en partie (MT) mobile sans fil.
